# EUROPEAN PATENT SPECIFICATION

(11) **EP 1 876 345 B1**
(45) Date of publication and mention of the grant of the patent: **09.09.2009**
(21) Application number: 07013296.4
(22) Date of filing: 06.07.2007
(51) Int. Cl.: F02F 5/00, F16J 9/26, C23C 14/16

(54) **Piston ring for internal combustion engines**
Kolbenring für Verbrennungsmotoren
Segment de piston pour moteurs à combustion interne

(30) Priority: 06.07.2006 JP 2006186547
(43) Date of publication of application: 09.01.2008
(73) Proprietor: Teikoku Piston Ring Co., Ltd., Tokyo, 1000005 (JP)
(72) Inventor: Kawai, Kiyoyuki, Okaya-shi, Nagano-ken, 394-0002 (JP)
(74) Representative: Davies, Christopher Robert

(56) References cited:
- EP-A- 0 841 413
- WO-A-20/05121403
- JP-A- 2002 266 697
- US-A1- 2005 170 162
- US-A1- 2005 218 603

## Description

### BACKGROUND OF INVENTION

### 1. Field of Invention

The present invention relates to a piston ring for internal combustion engines possessing superior resistance to wear and resistance to cracks and peeling, and capable of contributing to durability and a longer automobile service life amidst a harsh piston ring usage environment accompanied by stricter emission gas restrictions on automotive engines.

### 2. Description of Related Art

Tougher emission gas restrictions on automobile engines have spurred much progress in technology to reduce exhaust gas emissions including high pressure combustion, multiple injection of fuel and cooled EGR (exhaust gas recirculation). This type of technology increases the thermal load applied to the piston ring and the surface pressure during usage, and also adversely affects the lubrication environment due to contamination from corrosive components and dilution of the lubricating oil. In other words, the environment in which piston rings are used has become harsher compared to the past and greater wears, cracks and peeling are likely to occur. A surface treatment process is therefore needed that gives piston rings excellent resistance to wear, and crack resistance and peeling resistance.

Surface treatment is an effective method for improving the piston ring sliding characteristics. Methods have been proposed and come in practice for coating the outer circumferential sliding surface with a CrN film by the PVD (physical vapor deposition) technique (see the patent document 1), and a CrN film with oxygen and carbon in a solid solution state (see the patent document 2).
[Patent Document 1] Japanese Patent Non-Examined Publication No. 7-286262
[Patent Document 2] Japanese Patent Non-Examined Publication No. 10-306386

Technologies proposed for films possessing excellent wear resistance on sliding members include a film containing nitrides made from aluminum and/or silicon and/or zirconium within a wear-resistant layer consisting substantially of chromium nitride (see the patent document 3); or a film formed from a mixed composition of a crystal phase composed of metallic nitrides or metallic carbides or metallic carbo-nitrides and an amorphous phase (see the patent document 4); or method for forming those films (see the patent document 5).
[Patent Document 3] Japanese Patent Non-Examined Publication No. 2005-525515
[Patent Document 4] Japanese Patent Non-Examined Publication No. 2002-266697
[Patent Document 5] Japanese Patent Non-Examined Publication No. 2005-82823

In the patent document 3, the film formed on the sliding surface contains a specified chromium content of 20 to 60 percent, a silicon content of 10 to 50 percent, a nitrogen content of 35 to 55 percent, and a total chromium and silicon content of 45 to 70 percent in atomic ratio. Also, the film formed on the sliding surface contains a specified total content from 10 to 50 percent in at least two elements from among aluminum, silicon and zirconium, and a total content of metallic elements including chromium from 50 to 70 percent in atomic ratio.

In the patent document 4, the percentage of crystal phase in the film formed on the sliding surface is from 5 to 95 percent and the remainder is the amorphous phase. The amorphous phase is described as nitride or carbide or carbo-nitrides of elements in groups IIIb and IVb of the periodic table such as silicon (Si). Moreover, the example describes using a target with silicon mixed into the metallic chromium. The example yields a composite film where the crystal phase is formed of a nitride of chromium, and the amorphous phase is formed of a nitride of silicon.

The patent document 5 discloses a method for forming nanocomposite films composed of metallic nitrides and amorphous silicon-nitrogen by utilizing gases containing silicon as a silicon source besides the cathode, in order to increase the silicon content in the film.

US 2005/0218603 discloses a piston ring having an outer contact surface comprising nitrides of aluminium and/or silicum and or zirconium in a matrix of chromium-nitride based material. Where silicum is employed, the amount added to the coating is 10 to 50 atom %, which may provide a hard and wear resistant film but the film is brittle, cracks can occur on the film surface, and the coating may peel away. The present invention as claimed in claim 1 provides an improved film having silicon in a solid solution state in a crystal lattice at an atomic ratio between 1 and 9.5%.

### DISCLOSURE OF INVENTION

The harsher piston ring usage environment due to stricter exhaust gas regulations for automobile engines has increased amount of wear on a conventional CrN film, and CrN film with oxygen and carbon in a solid solution state. This increased wear shortens the durability and service life of the automobile.

However, when the silicon content is 10 percent or more in the film formed on the sliding surface (see the patent document 3), the film hardness increases and wear resistance improves, yet the film becomes brittle and cracks occur on the film surface due to friction resistance during sliding depending usage conditions. In other words, there is poor resistance to cracks. When the usage conditions become even harsher, localized peeling sometimes occurs in the film covering the sliding surface. In other words, there is poor resistance to peeling. Needless to say, when cracks and peeling occur in the film due to this low crack resistance and low peeling resistance, the performance or functionality of the part itself deteriorates. Cracks and peeling are prone to occur on the film of the piston ring in a state where the piston ring slides under high surface pressure due to a rise in combustion pressure, or fuel adheres to the bore walls due to early injection or delayed injection during multiple injection (when the engine lubricant has become diluted).

Also, when the silicon content is 10 percent or more in the film formed on the sliding surface (see the patent document 3), the surface roughness is prone to deteriorate and this sometimes accelerates wear on the mating surfaces. Machining the film surface by methods such as lapping to prevent this disadvantage is not desirable since concave pits tend to easily occur on the film surface, the outer appearance of the piston ring as a product deteriorates, and blow-by gas quantity sometimes increases.

In the patent document 4, the proportion of crystal phase in the film formed on the sliding surface is specified from 5 to 95 percent and the remainder specified for the amorphous phase (amorphous phase proportion is from 5 to 95%). However, the hardness of the film decreases when the proportion of the amorphous phase in the film is too high, and the wear resistance, crack resistance and peeling resistance tend to deteriorate. In other words, the film disclosed in the patent document 4 contains a large amorphous phase and is therefore not suitable for mutually improving the wear resistance, crack resistance and peeling resistance of the piston ring.

The patent document 4 moreover discloses no methods for controlling the ratio of the crystal phase to the amorphous phase.

In the patent document 5, a film with a silicon content exceeding 10 percent is fabricated by utilizing a gas containing silicon as a source of silicon besides the cathode, in order to form a nanocomposite film composed of metallic nitrides and amorphous silicon-nitrogen. The description that a silicon content of 20 percent yields the best film characteristics is observed. However, a film with a silicon content of 10 percent or more is not suitable for mutually improving the wear resistance, crack resistance and peeling resistance of the piston ring.

The object of the present invention is to provide a piston ring for internal combustion engines with wear resistance, crack resistance and peeling resistance.

The present invention employs the following means to resolve the aforementioned problems. Namely,
the piston ring for internal combustion engines of the present invention comprises a hard film formed on at least an outer circumferential sliding surface of the piston ring, wherein
the hard film includes chromium, nitrogen and silicon as structural elements, and the same crystal structure as CrN, and is composed of a crystal phase where silicon is contained in a solid solution state in a crystal lattice at an atomic ratio between 1 and 9.5 percent.

Increasing the silicon content in the hard film forms the amorphous phase including silicon, nitrogen, and chromium as structural elements. A proportion of amorphous phase that is too large will prevent the film from providing good wear resistance, crack resistance and peeling resistance.

The present invention may employ the following structure. Namely,
the piston ring for internal combustion engines of the present invention comprises a hard film formed on at least an outer circumferential sliding surface of the piston ring, wherein
the hard film is composed of a mixed phase of a crystal phase and an amorphous phase,
the crystal phase includes chromium, nitrogen and silicon as structural elements, and the same crystal structure as CrN, and moreover includes silicon contained in a solid solution state in a crystal lattice,
the amorphous phase includes silicon, nitrogen and chromium as structural elements,
the ratio of the amorphous phase in the hard film is 4.5 percent or less, and
the silicon content in the hard film is between 1 and 9.5 percent at an atomic ratio.

The hard film of the present invention may further contain one or more types of metallic elements selected from among aluminum, vanadium, titanium and zirconium. Namely, the piston ring for internal combustion engines of the present invention comprises a hard film composed of the aforementioned crystal phase, wherein the hard film includes one or more types of metallic elements selected from among aluminum, vanadium, titanium and zirconium as structural elements; and the one or more metallic elements are contained in a solid solution state in a crystal lattice, and the element content is 7 percent or less at an atomic ratio.

The piston ring for internal combustion engines of the present invention comprises a hard film composed of the aforementioned mixed phase including a crystal phase and an amorphous phase, wherein the hard film includes one or more types of metallic elements selected from among aluminum, vanadium, titanium and zirconium as structural elements, and the one or more metallic elements are contained as the amorphous phase structural elements as well as being contained in a solid solution state in a crystal lattice of the crystal phase; and the element content is 7 percent or less at an atomic ratio.

The hard film of the present invention may further contain one or more types of elements selected from among boron, carbon, oxygen and fluorine. Namely, the piston ring for internal combustion engines of the present invention comprises a hard film composed of the aforementioned crystal phase, wherein the hard film includes one or more types of elements selected from among boron, carbon, oxygen and fluorine as structural elements; and the one or more elements are contained in a solid solution state in a crystal lattice, and the element content is 10 percent or less at an atomic ratio.

The piston ring for internal combustion engines of the present invention comprises a hard film composed of the aforementioned mixed phase including a crystal phase and an amorphous phase, wherein the hard film includes one or more types of elements selected from among boron, carbon, oxygen and fluorine as structural elements; and the one or more elements are contained as the amorphous phase structural elements as well as being contained in a solid solution state in a crystal lattice of the crystal phase; and the element content is 10 percent or less at an atomic ratio.

The hard film was described as possessing a silicon content between 1 percent and 9.5 percent, however, a silicon content between 1 percent and 5 percent is preferable for obtaining good resistance to crack and resistance to peeling.

There is a correlation between the amorphous phase percentage and the silicon content in the hard film. Generally, the larger the silicon content, the larger the amorphous phase percentage. However, the ratio of the amorphous phase depends on the film forming conditions and so its ratio is not determined merely by the silicon content. Maintaining a high film forming temperature is effective in inhibiting formation of the amorphous phase as shown in this invention.

There is no improvement in wear resistance, and in crack resistance and peeling resistance when the silicon content in the hard film is below 1 percent at an atomic ratio. Increasing the silicon content lowers the crack resistance and peeling resistance but the crack resistance and peeling resistance can be improved at an atomic ratio of 9.5 percent or less. A silicon content of 5 percent or less is preferable for crack resistance and peeling resistance.

Increasing the silicon content in the hard film even further, forms an excessively large amorphous phase and lowers the wear resistance. At an amorphous phase ratio of 4.5 percent or less, there are virtually no adverse effects on wear resistance, and on crack resistance and peeling resistance, and the film can be utilized the same as if containing no amorphous phase.

Other elements besides silicon may also be added into the hard film. When one or more metallic elements selected from among aluminum, vanadium, titanium and zirconium are further added, the content of the added element is set to 7 percent or less since adding the element in excessive amounts accelerates formation of the amorphous phase, which lowers the wear resistance, crack resistance and peeling resistance.

When one or more elements selected from among boron, carbon, oxygen and fluorine are further added to the film, the content of the added element is set to 10 percent or less since adding the element in excessive amounts accelerates formation of the amorphous phase, which lowers the wear resistance, crack resistance and peeling resistance.

Utilizing the piston ring of this invention in automobile engines can suppress the occurrence of cracks and peeling and the greater wear caused by a more severe usage environment of the piston ring brought about by tougher gas emission regulations, and can increase the durability and service life of the automobile.

### BRIEF DESCRIPTION OF DRAWINGS

FIG. 1 is a longitudinal sectional view showing a part of a piston ring of one preferred embodiment of the present invention;
FIG. 2 is a longitudinal sectional view showing a part of a piston ring of another preferred embodiment of the present invention;
FIG. 3 is a frontal view showing an outline of a reciprocating friction testing machine;
FIG. 4 is a frontal view showing an outline of a VDH testing machine;

### DESCRIPTION OF PREFERRED EMBODIMENTS

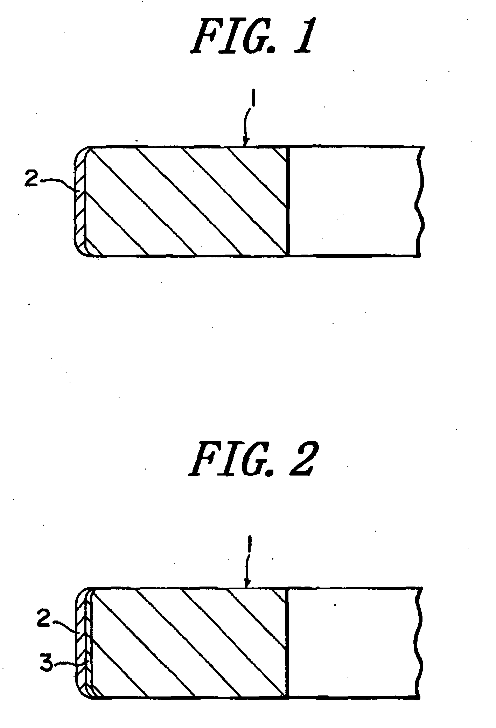

The preferred embodiments of the present invention are described next. FIG. 1 is a longitudinal sectional view showing a part of a piston ring. A piston ring 1 is a ring with a rectangular cross-section and formed from steel, cast iron, titanium or titanium alloy, etc.

A hard film 2 covers the outer circumferential surface of the piston ring 1. The hard film 2 may be formed from any of the following structures.
(1) A hard film made up of chromium, nitrogen and silicon serving as structural elements, and having the same crystal structure as CrN, and moreover being composed of a crystal phase containing silicon in a solid solution state in a crystal lattice at an atomic ratio between 1 and 9.5 percent.
(2) A hard film made up of chromium, nitrogen and silicon serving as structural elements, and having the same crystal structure as CrN, and being composed of a mixed phase of an amorphous phase of silicon, nitrogen and chromium as structural elements and a crystal phase containing silicon in a solid solution state in a crystal lattice, wherein the ratio of the amorphous phase in the hard film is 4.5 percent or less, and the silicon content in the hard film is between 1 and 9.5 percent at an atomic ratio.
(3) A hard film according to the above aspect (1), wherein the hard film further includes one or more types of metallic elements selected from among aluminum, vanadium, titanium and zirconium as structural elements; and the one or more metallic elements are contained in a solid solution state in a crystal lattice, and the element content is 7 percent or less at an atomic ratio.
(4) A hard film according to the above aspect (2), wherein the hard film further includes one or more types of metallic elements selected from among aluminum, vanadium, titanium and zirconium as structural elements, and the one or more metallic elements are contained as the amorphous phase structural elements as well as being contained in a solid solution state in a crystal lattice of the crystal phase; and the element content is 7 percent or less at an atomic ratio.
(5) A hard film according to the above aspect (1), wherein the hard film further includes one or more types of elements selected from among boron, carbon, oxygen and fluorine as structural elements; and the one or more elements are contained in a solid solution state in a crystal lattice, and the element content is 10 percent or less at an atomic ratio.
(6) A hard film according to the above aspect (3), wherein the hard film further includes one or more types of elements selected from among boron, carbon, oxygen and fluorine as structural elements; and the one or more elements are contained in a solid solution state in a crystal lattice, and the element content is 10 percent or less at an atomic ratio.
(7) A hard film according to the above aspect (2), wherein the hard film further includes one or more types of elements selected from among boron, carbon, oxygen and fluorine as structural elements; and the one or more elements are contained as the amorphous phase structural elements as well as being contained in a solid solution state in a crystal lattice of the crystal phase; and the element content is 10 percent or less at an atomic ratio.
(8) A hard film according to the above aspect (4), wherein the hard film further includes one or more types of elements selected from among boron, carbon, oxygen and fluorine as structural elements; and the one or more elements are contained as the amorphous phase structural elements as well as being contained in a solid solution state in a crystal lattice of the crystal phase; and the element content is 10 percent or less at an atomic ratio.

The hard film 2 may be formed by PVD methods such as arc ion plating or sputtering. The method for forming the hard film of the above aspects (1) and (2) by the arc ion plating method utilizing a target formed from sintered chromium and silicon mixed compound is described next.

After degreasing and cleaning, a piston ring is placed on a rotation table within a film-forming chamber, and the air is exhausted to raise a vacuum. When the vacuum level reaches approximately 1.3 × 10⁻³ Pa, a heater inside the chamber heats the piston ring to approximately 673 K and the rotation table is driven simultaneously. The vacuum level temporarily weakens due to release of water vapor and gas components from the surface of the piston ring. When the vacuum level rises again to approximately 5 × 10⁻³ Pa, a small quantity of nitrogen gas is supplied, and an arc discharge occurs between the target and anode. The bias voltage of about -500 to -1,000 volts at this time is applied to the piston ring, and ions from the arc discharge strike the piston ring surface, performing the so-called bombard cleaning. This bombard cleaning raises the purity level of the piston ring surface, and enhances the adhesion of the hard film.

The bias voltage is then lowered at 0 to -100 volts approximately, and the supply of nitrogen gas is increased and the pressure in the chamber becomes 0.7 Pa to 4 Pa approximately, and the film is formed. The temperature of the piston ring during film-forming may be 723 K or higher in order to suppress the formation of an amorphous phase. Factors such as the arc current during film-forming or the film-forming time may be changed to control the thickness of the hard film. There are no particular specifications for the thickness of the hard film in the present invention but the thickness is preferably 5 micrometers to 50 micrometers approximately.

Prior to applying the hard film 2, an underlayer film 3 (See FIG. 2) of metallic chromium film or CrN film not containing silicon may be coated on the outer circumferential surface of the base material in the piston ring 1. In this case, besides a mixed cathode of chromium and silicon, a metallic chromium cathode is utilized, to first form an underlayer film of chromium or CrN, and the mixed cathode of chromium and silicon is then utilized to deposit the hard film of chromium, nitrogen, and silicon as structural elements. Forming this type of underlayer film improves the adhesion of the hard film.

Altering the silicon content of the target can change the silicon content in the hard film. However, the ratio of chromium to silicon within the target will not completely match the ratio of chromium to silicon within the fabricated film. The ratio of chromium to silicon within the film is usually a lower value than the ratio of chromium to silicon within the target. This lower value is due to the fact that silicon has a lower evaporating efficiency than chromium. The chromium within the target reacts with the nitrogen gas to form the CrN. The silicon within the target is contained in a solid solution state in a crystal lattice of the CrN or forms an amorphous phase containing silicon but does not form a particular compound.

Earlier, the amorphous phase was described as tending to be easily formed when there is excessive silicon content in the hard film. The amorphous phase also tends to be formed when an element such as aluminum is added or when the film-forming temperature is low. In other words, these methods can be utilized to change the percentage of the amorphous phase.

The silicon content in the hard film can be quantified by an electron beam microanalyzer or an X-ray fluorescence analysis apparatus.

When forming the hard films described in the aforementioned aspects (3) through (8) or in other words when purposely adding an element other than chromium, silicon and nitrogen to the hard film, the element may be added to the target or may be supplied as a gas. The elements aluminum, vanadium, titanium, zirconium and boron may be added to the target. The elements carbon, oxygen and fluorine may be supplied as a gas. If for example using carbon, then CH₄ gas, C₂H₄ gas or C₂H₂ gas may be utilized as a carbon source. If using oxygen, then oxygen gas may be utilized as an oxygen source. If using fluorine, then carbon tetrafluoride gas may be utilized as a fluorine source. The hard film may include elements other than described above as impurities in the above described PVD method.

Whether or not amorphous phase is present in the hard film can be investigated by X-ray diffraction measurement, electron diffraction measurement or high-resolution transmission electron microscope observation (lattice image observation). Observation by high-resolution transmission electron microscope is better for cases where there is little amorphous phase or when evaluating the ratio of the crystal phase to amorphous phase. In the present invention, the ratio of the crystal phase to amorphous phase is determined by finding the surface area ratio in images from high-resolution transmission electron microscope.

Tests were made to evaluate the wear resistance, crack resistance and peeling resistance of the hard film fabricated by the above described arc ion plating method.

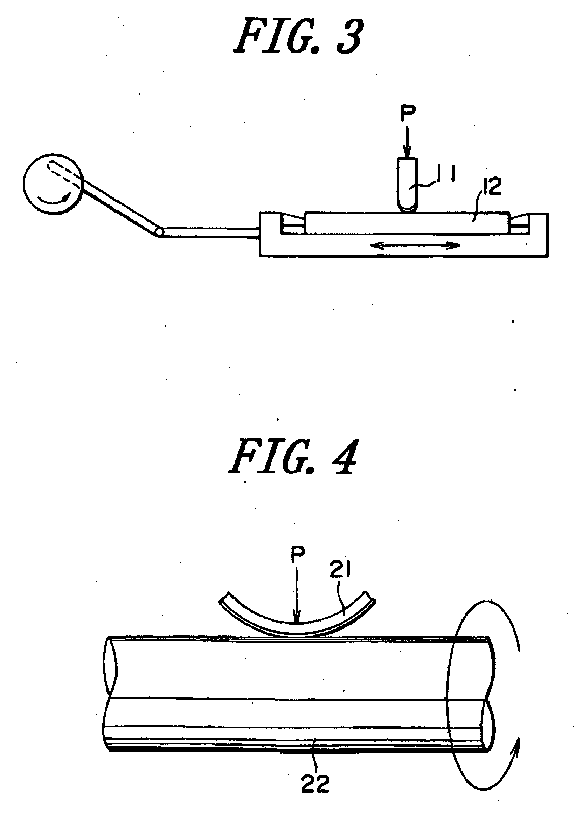

The wear resistance test was performed using the reciprocating friction testing machine shown in FIG. 3. The reciprocating friction testing machine applies a load P from a spring load to press an upper test piece 11 equivalent to a piston ring, against a lower test piece 12 equivalent to a cylinder bore. The reciprocating movement of the lower test piece 12 induces a sliding motion between both test pieces. A tubing pump or an air dispenser supplied the lubricating oil. The wear length on the upper test piece 11 was measured with a surface roughness meter after operating the friction testing machine for a fixed amount of time at a specified load and speed. The wear length as the length of wear along the axial direction was found by the difference in contour of the lower test piece 12 before and after test operation. Test conditions were a load of 50N, a speed of 300 cpm, and a time of 60 minutes.

Test results (Table 1) shown for the wear length, are values relative to a value of 1 set for CrN film prepared as the comparative example. The shorter the wear length, the better the resistance to wear becomes.

The crack resistance and peeling resistance tests were performed using the VDH testing machine shown in FIG. 4. A load P was applied to a test piece 21 of about 1 to 2 centimeters cut from a piston ring and the test piece 21 was pressed against a rotor 22 rotating at a fixed speed to make scuffing occur. After operating the testing machine in this state for a fixed period of time, the sliding surface was observed for cracks or peeling.
Testing was performed a number of times while varying the load. A tubing pump or an air dispenser supplied the lubricating oil. Test conditions were a speed of 1,000 rpm, a time of 1 minute, and an initial load of 40N that was gradually increased until cracks or peeling occurred.

Test results (Table 1) for the crack-peeling load, are values relative to a value of 1 set for CrN film prepared as the comparative example. The higher the crack-peeling load, the better the resistance to crack and peeling becomes.

**[Table 1]**

| | No. | Film type | Si at.% | Al at.% | O, C at.% | Amorphous phase Area % | Wear length | Crack-Peeling load |
|---|---|---|---|---|---|---|---|---|
| Embodiment | 1 | Cr-Si-N | 1.0 | - | - | 0 | 0.9 | 1.1 |
| | 2 | | 3.9 | - | - | 0 | 0.6 | 2.0 |
| | 3 | | 9.5 | - | - | 2.1 | 0.5 | 1.4 |
| | 4 | Cr-Si-Al-N | 3.6 | 1.4 | - | 1.1 | 0.6 | 1.9 |
| | 5 | | 9.0 | 6.2 | - | 4.5 | 0.6 | 1.2 |
| | 6 | Cr-Si-O-N | 4.1 | - | 0:3.5 | 1.2 | 0.6 | 1.9 |
| | 7 | Cr-Si-C-N | 3.2 | - | C:8.1 | 1.2 | 0.9 | 1.2 |
| Comparative Example | 1 | CrN | - | - | - | 0 | 1.0 | 1.0 |
| | 2 | Cr-Si-N | 0.6 | - | - | 0 | 1.0 | 1.0 |
| | 3 | | 10.0 | - | - | 2.3 | 0.7 | 0.9 |
| | 4 | | 13.8 | - | - | 5.0 | 1.0 | 0.8 |
| | 5 | | 15.3 | - | - | 6.7 | 1.1 | 0.7 |
| | 6 | Cr-Si-Al-N | 9.1 | 7.5 | - | 7.0 | 1.1 | 0.7 |
| | 7 | | 8.2 | 23.1 | - | 45.0 | 2.5 | 0.5 |
| | 8 | Cr-Si-C-N | 3.5 | - | C:11.2 | 2.6 | 0.7 | 0.8 |

Results from Table 1 reveal the following.
(1) The wear resistance, the crack resistance and peeling resistance were both improved at a silicon content of 1 percent or more in the hard film (embodiment 1), and an especially strong effect was observed (embodiment 2).
(2) The crack resistance and peeling resistance deteriorated somewhat at a silicon content of 9.5 percent but was still superior to the CrN film (embodiment 3).
(3) Adding a small quantity of aluminum yielded the same effect as when no aluminum was added to the film (embodiment 4). However, the crack resistance and peeling resistance tend to deteriorate when the content was in the vicinity of 7 percent but was superior to the CrN film (embodiment 5).
(4) Even when a small quantity of oxygen was added to the film, the same effect was obtained as when no oxygen was added (embodiment 6).
(5) When the carbon content added to the film approached 10 percent, the crack resistance and peeling resistance tend to deteriorate compared to film where no carbon was added, however, the crack resistance and peeling resistance was superior to the CrN film (embodiment 7).
(6) When the silicon content in the hard film was lower than 1 percent at an atomic ratio, no superiority in wear resistance, crack resistance and peeling resistance was found compared to the CrN film (comparative example 2).
(7) When the silicon content was 10 percent, the resistance to wear remained at a high level but the crack resistance and peeling resistance deteriorated (comparative example 3).
(8) When the silicon content increased even further and the amorphous phase ratio reached 5 percent, the crack resistance and peeling resistance deteriorated even more (comparative example 4).
(9) When the silicon content increased even further and the amorphous phase ratio exceeded 5 percent, the wear resistance also deteriorated as well as the crack resistance and peeling resistance (comparative example 5).
(10) When the aluminum additive content exceeded 7 percent, the formation of amorphous phase was accelerated, and the wear resistance, the crack resistance and peeling resistance all deteriorated (comparative examples 6, 7).
(11) When the carbon additive content exceeded 10 percent, the resistance to wear was excellent but the crack resistance and peeling resistance deteriorated (comparative example 8).

In the examples described in the above embodiments, the hard film of the present invention covered only the outer circumferential surface of the piston ring. However, the present invention is not limited to these examples and besides the outer circumferential surface of the piston ring, the hard film of the present invention may cover the upper and lower surfaces and the inner circumferential surface.

## Claims

1. A piston ring for internal combustion engines comprising a hard film formed on at least an outer circumferential sliding surface of the piston ring, wherein
the hard film includes chromium, nitrogen and silicon as structural elements, and the same crystal structure as CrN, and is composed of a crystal phase containing silicon in a solid solution state in a crystal lattice at an atomic ratio between 1 and 9.5 percent.

2. A piston ring for internal combustion engines comprising a hard film formed on at least an outer circumferential sliding surface of the piston ring, wherein
the hard film is composed of a mixed phase of a crystal phase and an amorphous phase,
the crystal phase includes chromium, nitrogen and silicon as structural elements, and the same crystal structure as CrN, and moreover includes silicon contained in a solid solution state in a crystal lattice,
the amorphous phase includes silicon, nitrogen and chromium as structural elements,
the ratio of the amorphous phase in the hard film is 4.5 percent or less, and
the silicon content in the hard film is between 1 and 9.5 percent at an atomic ratio.

3. A piston ring for internal combustion engines as claimed in claim 1, wherein the hard film includes one or more types of metallic elements selected from among aluminum, vanadium, titanium and zirconium as structural elements; and the one or more metallic elements are contained in a solid solution state in a crystal lattice, and the element content is 7 percent or less at an atomic ratio.

4. A piston ring for internal combustion engines as claimed in claim 2, wherein the hard film includes one or more types of metallic elements selected from among aluminum, vanadium, titanium and zirconium as structural elements, and the one or more metallic elements are contained as the amorphous phase structural elements as well as being contained in a solid solution state in a crystal lattice of the crystal phase; and the element content is 7 percent or less at an atomic ratio.

5. A piston ring for internal combustion engines as claimed in claim 1 or claim 3, wherein the hard film includes one or more types of elements selected from among boron, carbon, oxygen and fluorine as structural elements; and the one or more elements are contained in a solid solution state in a crystal lattice, and the element content is 10 percent or less at an atomic ratio.

6. A piston ring for internal combustion engines as claimed in claim 2 or claim 4, wherein the hard film includes one or more types of elements selected from among boron, carbon, oxygen and fluorine as structural elements; and the one or more elements are contained as the amorphous phase structural elements as well as being contained in a solid solution state in a crystal lattice of the crystal phase; and the element content is 10 percent or less at an atomic ratio.

## Patentansprüche

1. Kolbenring für Verbrennungsmotoren mit einem Hartfilm, der wenigstens auf einer äußeren umgebenden Gleitoberfläche des Kolbenrings aufgebracht ist, wobei
der Hartfilm Chrom, Stickstoff und Silizium als strukturelle Elemente und die gleiche Kristallstruktur wie CrN aufweist, und aus einer kristallinen Phase mit Silizium in einem Mischkristallzustand in einem Kristallgitter mit einem atomaren Verhältnis zwischen 1 und 9,5 % gebildet ist.

2. Kolbenring für Verbrennungsmotoren mit einem Hartfilm, der wenigstens auf einer äußeren umgebenden Gleitoberfläche des Kolbenrings aufgebracht ist, wobei
der Hartfilm aus einer gemischten Phase aus einer kristallinen Phase und einer amorphen Phase zusammengesetzt ist,
die kristalline Phase Chrom, Stickstoff und Silizium als strukturelle Elemente und die gleiche Kristallstruktur wie CrN aufweist, und darüber hinaus Silizium in einem Mischkristallzustand in einem Kristallgitter beinhaltet,
die amorphe Phase Chrom, Stickstoff und Silizium als strukturelle Elemente beinhaltet,
der Anteil der amorphen Phase in dem Hartfilm 4,5 % oder weniger beträgt, und
der Siliziumgehalt in dem Hartfilm zwischen 1 und 9,5 % in einem atomaren Verhältnis beträgt.

3. Kolbenring für Verbrennungsmotoren nach Anspruch 1, bei dem der Hartfilm eine oder mehrere Arten metallischer Elemente aufweist, die aus Aluminium, Vanadium, Titan und Zirkon als strukturelle Elemente ausgewählt sind; und wobei das eine oder die mehreren metallischen Elemente in einem Mischkristallzustand in einem Kristallgitter enthalten sind, und wobei der Elementgehalt 7 % oder weniger in einem atomaren Verhältnis beträgt.

4. Kolbenring für Verbrennungsmotoren nach Anspruch 2, bei dem der Hartfilm eine oder mehrere Arten metallischer Elemente aufweist, die aus Aluminium, Vanadium, Titan und Zirkon als strukturelle Elemente ausgewählt sind; und wobei das eine oder die mehreren metallischen Elemente als die Amorphphasen-Strukturelemente enthalten sind und in einem Mischkristallzustand in einem Kristallgitter der kristallinen Phase enthalten sind; und wobei der Elementgehalt 7 % oder weniger in einem atomaren Verhältnis beträgt.

5. Kolbenring für Verbrennungsmotoren nach Anspruch 1 oder 3, bei dem der Hartfilm eine oder mehrere Arten metallischer Elemente aufweist, die aus Bor, Kohlenstoff, Sauerstoff und Fluor als strukturelle Elemente ausgewählt sind; und wobei das eine oder die mehreren Elemente in einem Mischkristallzustand in einem Kristallgitter enthalten sind, und wobei der Elementgehalt 10 % oder weniger in einem atomaren Verhältnis beträgt.

6. Kolbenring für Verbrennungsmotoren nach Anspruch 2 oder 4, bei dem der Hartfilm eine oder mehrere Arten von Elementen aufweist , die aus Bor, Kohlenstoff, Sauerstoff und Fluor als strukturelle Elemente ausgewählt sind; und wobei das eine oder die mehreren Elemente als Amorphphasen-Strukturelemente enthalten sind und in einem Mischkristallzustand in einem Kristallgitter enthalten sind; und wobei der Elementgehalt 10 % oder weniger in einem atomaren Verhältnis beträgt.

## Revendications

1. Segment de piston pour moteurs à combustion interne comprenant une couche dure formée sur au moins une surface circonférentielle externe de glissement du segment de piston, dans lequel
la couche dure comprend du chrome, de l'azote et du silicium comme éléments structuraux, a la même structure cristalline que CrN, et est composée d'une phase cristalline contenant du silicium à l'état de solution solide dans un réseau cristallin à un rapport atomique compris entre 1 et 9,5 pour cent.

2. Segment de piston pour moteurs à combustion interne comprenant une couche dure formée sur au moins une surface circonférentielle externe de glissement du segment de piston, dans lequel
la couche dure est composée d'une phase mixte constituée d'une phase cristalline et d'une phase amorphe,
la phase cristalline comprend du chrome, de l'azote et du silicium comme éléments structuraux, a la même structure cristalline que CrN, et comprend en outre du silicium contenu à l'état de solution solide dans un réseau cristallin,
la phase amorphe comprend du silicium, de l'azote et du chrome comme éléments structuraux,
la proportion de la phase amorphe dans la couche dure est de 4,5 pour cent ou moins, et
la teneur en silicium dans la couche dure est comprise entre 1 et 9,5 pour cent en rapport atomique.

3. Segment de piston pour moteurs à combustion interne selon la revendication 1, dans lequel la couche dure comprend un ou plusieurs types d'éléments métalliques choisis parmi l'aluminium, le vanadium, le titane et le zirconium comme éléments structuraux, le ou les éléments métalliques sont contenus à l'état de solution solide dans un réseau cristallin, et la teneur en élément (s) est de 7 pour cent ou moins en rapport atomique.

4. Segment de piston pour moteurs à combustion interne selon la revendication 2, dans lequel la couche dure comprend un ou plusieurs types d'éléments métalliques choisis parmi l'aluminium, le vanadium, le titane et le zirconium comme éléments structuraux, le ou les éléments métalliques sont contenus comme éléments structuraux de la phase amorphe, mais aussi à l'état de solution solide dans un réseau cristallin de la phase cristalline, et la teneur en élément(s) est de 7 pour cent ou moins en rapport atomique.

5. Segment de piston pour moteurs à combustion interne selon la revendication 1 ou la revendication 3, dans lequel la couche dure comprend un ou plusieurs types d'éléments choisis parmi le bore, le carbone, l'oxygène et le fluor comme éléments structuraux, le ou les éléments sont contenus à l'état de solution solide dans un réseau cristallin, et la teneur en élément(s) est de 10 pour cent ou moins en rapport atomique.

6. Segment de piston pour moteurs à combustion interne selon la revendication 2 ou la revendication 4, dans lequel la couche dure comprend un ou plusieurs types d'éléments choisis parmi le bore, le carbone, l'oxygène et le fluor comme éléments structuraux, le ou les éléments sont contenus comme éléments structuraux de la phase amorphe, mais aussi à l'état de solution solide dans un réseau cristallin de la phase cristalline, et la teneur en élément(s) est de 10 pour cent ou moins en rapport atomique.
